# EUROPEAN PATENT SPECIFICATION

(11) **EP 1 649 501 B1**
(45) Date of publication and mention of the grant of the patent: **03.01.2007**
(21) Application number: 03817953.7
(22) Date of filing: 30.07.2003
(51) Int. Cl.: H01L 21/28, H01L 29/51

(54) **HIGH-K DIELECTRIC FILM, METHOD OF FORMING THE SAME AND RELATED SEMICONDUCTOR DEVICE**
DIELEKTRISCHER FILM MIT HOHEM K, HERSTELLUNGSVERFAHREN DAFÜR UND DIESBEZÜGLICHES HALBLEITERBAUELEMENT
FILM DIELECTRIQUE A CONSTANTE DIELECTRIQUE ELEVEE, SON PROCEDE DE FORMATION ET DISPOSITIF A SEMI-CONDUCTEUR ASSOCIE

(43) Date of publication of application: 26.04.2006
(73) Proprietor: Infineon Technologies AG, 81669 München (DE)
(72) Inventor: LIM, Chan, 300 Hsin-chu (TW); LEE, Kilho, 300 Hsin-chu (TW)
(74) Representative: Kindermann, Peter
(86) International application number: PCT/EP2003/050352
(87) International publication number: WO 2005/015621

(56) References cited:
- EP-A- 1 271 632
- WO-A-01/66832
- US-A- 6 013 553
- US-B1- 6 291 866
- KOYAMA M ET AL: "Effects of nitrogen in HfSiON gate dielectric on the electrical and thermal characteristics" INTERNATIONAL ELECTRON DEVICES MEETING 2002. IEDM. TECHNICAL DIGEST. SAN FRANCISCO, CA, DEC. 8 - 11, 2002, NEW YORK, NY: IEEE, US, 8 December 2002 (2002-12-08), pages 849-852, XP010626172 ISBN: 0-7803-7462-2 cited in the application
- SHANWARE A ET AL: "Reliability evaluation of HfSiON gate dielectric film with 12.8 A/spl deg/ SiO2 equivalent thickness" INTERNATIONAL ELECTRON DEVICES MEETING 2001. IEDM. TECHNICAL DIGEST. WASHINGTON, DC, DEC. 2 - 5, 2001, NEW YORK, NY: IEEE, US, 2 December 2001 (2001-12-02), pages 661-664, XP010575093 ISBN: 0-7803-7050-3
- ROTONDARO A L P ET AL: "ADVANCED CMOS TRANSISTORS WITH A NOVEL HFSION GATE DIELECTRIC" 2002 SYMPOSIUM ON VLSI TECHNOLOGY. DIGEST OF TECHNICAL PAPERS. HONOLULU, JUNE 11 - 13, 2002, SYMPOSIUM ON VLSI TECHNOLOGY, NEW YORK, NY: IEEE, US, 11 June 2002 (2002-06-11), pages 148-149, XP001109853 ISBN: 0-7803-7312-X
- VISOKAY M.R. ET AL: "Application of HfSiON as a gate dielectric material" APPLIED PHYSICS LETTERS, vol. 80, no. 17, 29 April 2002 (2002-04-29), pages 3183-3185, XP002264995
- QUEVEDO-LOPEZ M. A. ET AL: "Effect of N incorporation on boron penetration from p+ polycrystalline-Si through HFSixOy films" APPLIED PHYSICS LETTERS, vol. 82, no. 26, 30 June 2003 (2003-06-30), pages 4669-4671, XP002264996

## Description

The present invention relates to a high-k dielectric film, a method of forming the same and related semiconductor devices, and in particular to high-k dielectric films related to a gate dielectric for field effect semiconductor devices or a capacitor dielectric for trench capacitors in integrated circuits.

For forming semiconductor devices like CMOS devices (Complementary Metal Oxide Semiconductor), MOSFET devices (Metal Oxide Semiconductor Field Effect Transistor) or high memory devices such as DRAMs (Dynamic Random Access Memories), it is often necessary to form a thin, high dielectric constant (high-k) film onto a substrate, such as a silicon wafer. A variety of techniques has been developed to form such thin films on a semiconductor wafer.

In the past, gate dielectric layers have been formed using silicon dioxide. The scaling down of the above described devices, however, has increased the demand for gate dielectrics with a higher dielectric constant than silicon dioxide. This is necessary to reach ultra thin oxide equivalent thicknesses (EOT, Equivalent Oxide Thickness) without compromising gate leakage current.

In detail, as semiconductor devices have scaled to smaller dimensions, effective gate dielectric thickness has gotten thinner. The continued scaling of conventional gate dielectrics, such as SiO₂ and SiOₓN_{y}, has almost reached the fundamental limits of very high gate leakage current, due to direct tunneling, which is not acceptable in a scaled device requirement of a low leakage current. In order to suppress the high leakage current, several high-k films of transition metal oxide and silicate, such as HfO₂, ZrO₂, Hf-aluminate, Zr-aluminate, Zr-silicate, Hf-silicate and a lanthanide oxide like La₂O₃, Pr₂O₃, and Gd₂O₃, have been studied in replacement of SiO₂ and SiOₓN_{y}.

However, these conventional materials have turned out to show a plurality of disadvantages. According to S. OHMI, et al., "Rare earth metal oxide gate thin films prepared by E-beam deposition", International Workshop on Gate Insulator 2001, Tokyo, Japan, it is known that ZrO₂ or HfO₂ has shown micro crystal formation, resulting in high leakage current.

Document Koyama M. et al.: "Effects of Nitrogen in HfSiON Gate Dielectric on the Electrical and Thermal Characteristics", International Electron Devices Meeting 2002, IEDM, Technical Digest, SanFrancisco, CA, Dec. 8-11, 2002, New York, NY: IEEE, pages 849-852, on which the preamble of claims 1 and 9 is based discloses a high-k dielectric film for a semiconductor device being formed on a substrate as well as a method of forming the same, wherein a layer of metal-silicon-oxynitride comprises a first nitrogen content and a first silicon content.

Furthermore, from J. H. LEE, et al., "Poly-Si gate CMOSFETs with HfO₂-Al₂O₃ laminate gate dielectric for low power applications", Tech. Dig. VLSI, page 84, 2002, it is known that HfO₂-Al₂O₃ laminate or Hf-aluminate have serious mobility degradation due to fixed charges in the high-k dielectric film.

Moreover, TAKESHI, YAMAGUCHI, et al., "Additional scattering effects for mobility degradation in Hf-silicate gate MISFETs" Tech. Dig. IEDM 2002 reports that in case of Zr-silicate or Hf-silicate, phase separation of the film into HfO₂ and SiO₂ regions by the high temperature anneal induces also mobility degradation.

Document WO 01/66832 discloses the formation of thin films by atomic layer deposition, whereby the composition of the film can be varied from monolayer to monolayer, thereby providing a graded gate dielectric. In detail, the gate dielectric can be varied to oxynitride or to pure high-k material.

For lanthanide oxides, leakage current results have indicated that lanthanide oxides may be possible candidates of future dielectrics. However, according to H. IWAI, et al., "Advanced gate dielectric materials for Sub-100nm CMOS", Tech. Dig. IEDM 2002, it is reported that these lanthanide oxides also form interfacial layers on Si substrates after subsequent thermal annealing, which may indicate thermal instability of these lanthanide oxides.

Moreover, an impurity penetration such as boron penetration from e.g. a gate layer to a Si substrate is a further problem to be solved by these high-k dielectric films. Even though nitrogen incorporation on HfSiₓO_{y} has been known to suppress such a e.g. boron penetration and improve thermal stability, it was also reported that the very high Si content of Si/[Si+Hf] ratio of over 80 % in HfSiₓO_{y}N_{z} is required to prevent flat band voltage shift, resulting in seriously reducing dielectric constant of the film even with a high nitrogen content of 30 atomic percent (see M. KOYAMA, et al. "Effects of nitrogen in HfSiON gate dielectric on the electrical and thermal characteristics", Tech. Dig. IEDM 2002, 34-1). This low-k dielectric film of the very high Si content HfSiₓO_{y}N_{z} is the almost same conventional SiOₓN_{y} in terms of dielectric constant and is not meaningful any more in view of replacement of the SiOₓN_{y}. Other technical problems of the formation of respective films on Si substrate are that a high nitrogen concentration at the interface between the dielectric layer and the Si substrate can be induced by subsequent high thermal annealing to degrade mobility.

It is, therefore, a need to provide an improved high-k dielectric film, a method of forming the same and related semi-conductor devices.

In accordance with the present invention, a high-k dielectric film for a semiconductor device being formed on a substrate comprises at least a bottom layer of metal-silicon-oxynitride having a first nitrogen content and a first silicon content, and a top layer of metal-silicon-oxynitride having a second nitrogen content and a second silicon content, wherein said second nitrogen content of the top layer is higher than said first nitrogen content of the bottom layer and said second silicon content of the top layer is higher than said first silicon content of the bottom layer.

According to one embodiment, the high-k dielectric film constitutes a multilayer stack comprising at least one middle layer of metal-silicon-oxynitride being formed between said bottom layer and said top layer having a further nitrogen content and a further silicon content wherein the respective further nitrogen and silicon contents are between said respective first and second nitrogen and silicon contents.

According to a preferred embodiment of the present invention, a thickness of the top layer is equal to or lower than the sum of thicknesses of the remaining layers in the high-k dielectric film.

The method of forming a high-k dielectric film comprises the steps of forming a bottom layer of metal-silicon-oxynitride having a first nitrogen content and a first silicon content on a substrate, and forming a top layer of metal-silicon-oxynitride having a second nitrogen content and a second silicon content, wherein said second nitrogen content is higher than said first nitrogen content and said second silicon content is higher than said first silicon content of the respective layers.

In order to further improve a mobility particularly when used as a gate dielectric in field effect transistors, the method further includes the step of forming a substrate interface layer of silicon-oxide on the substrate before forming the bottom layer.

Further, at least one middle layer of metal-silicon-oxynitride having a further nitrogen content and a further silicon content is formed on the bottom layer, wherein the respective further nitrogen content and the further silicon content is higher than that of the preceding layer.

In an alternative embodiment, the method of forming a high-k dielectric film comprises the steps of forming a pre-bottom layer of metal-silicon-oxide having a first silicon content on a substrate, forming a pre-top layer of metal-silicon-oxide having a second silicon content, wherein the second silicon content is higher than the first silicon content, and performing N₂ plasma treatment to convert said pre-bottom layer to a metal-silicon-oxynitride bottom layer having a first nitrogen content and said pre-top layer to a metal-silicon-oxynitride top layer having a second nitrogen content, wherein said second nitrogen content is higher than said first nitrogen content.

Also in this alternative embodiment at least one pre-middle layer of metal-silicon-oxide having a further silicon content is formed, wherein the respective further silicon content is higher than that of the preceding layer, and wherein during the N₂ plasma treatment at least one pre-middle layer is converted to at least one metal-silicon-oxynitride middle layer having a further nitrogen content, wherein the respective further nitrogen content is higher than that of the preceding layer.

The objects and advantages of the invention will become apparent upon reading the following detailed description and upon reference to the accompanying drawings in which:
Figures 1A and 1B are partial cross-sectional views showing essential steps for producing a high-k dielectric film according to a first embodiment;
Figure 2 is a partial cross-sectional view of the high-k dielectric film according to a second embodiment;
Figures 3A to 3D are partial cross-sectional views showing essential steps for producing a high-k dielectric film according to a third embodiment;
Figure 4 is a partial cross-sectional view of a field effect semiconductor device using the high-k dielectric film; and
Figure 5 is a partial cross-sectional view of a trench capacitor using the high-k dielectric film.

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed. On the contrary, the intention is to cover all modification, equivalents and alternatives falling within the spirit and scope of the present invention.

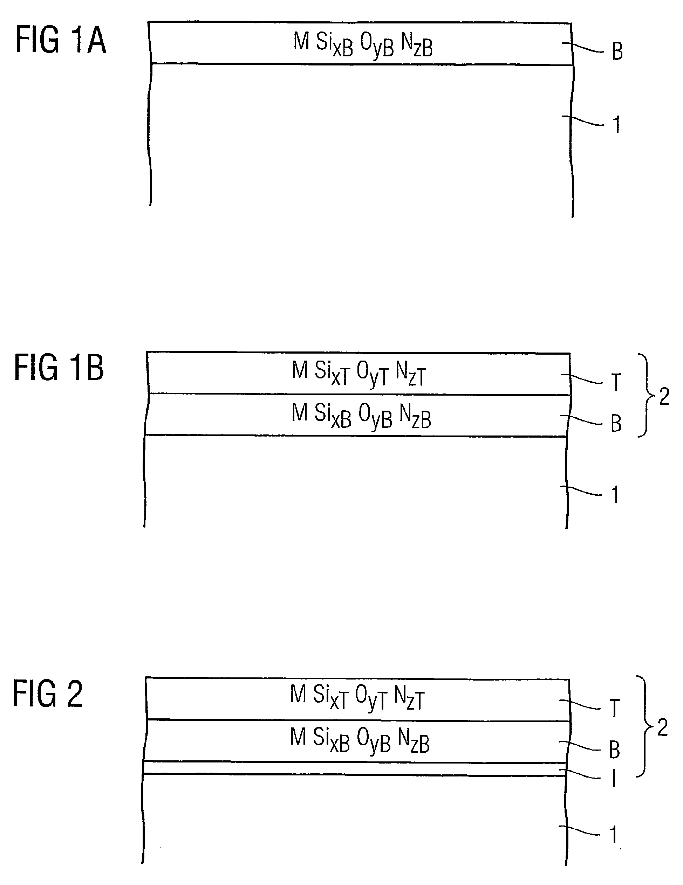

Figures 1A and 1B show partial cross-sections illustrating essential steps for producing a high-k dielectric film according to a first embodiment of the present invention.

According to Figure 1A a monocrystalline Si substrate 1 is used as semiconductor substrate, on the surface of which a bottom layer B of metal-silicon-oxynitride (MSi_{xB}O_{yB}N_{zB}) is formed by layer deposition methods.

According to Figure 1B on the surface of the bottom layer B a top layer T is formed by the same metal-silicon-oxynitride, however, having different silicon content and nitrogen content. In detail, the deposited top layer T constitutes MSiₓ-_{T}O_{yT}N_{zT} having a second nitrogen content zT and a second silicon content xT. The first and second nitrogen contents of the bottom and top layer B and T as well as the first and second silicon contents xB and xT are selected in such a way that the second nitrogen content zT of the top layer T is higher than the first nitrogen content zB of the bottom layer and the second silicon content xT of the top layer T is higher than the first silicon content xB of the bottom layer.

The indices x, y and z or xB, yB and zB or xT, yT and zT in the MSiₓO_{y}N_{z} layers are real positive values indicating atomic percentage in a molecular. Nitrogen atomic percentage in respective layer is calculated by (z/(1+x+y+z))×100. Usually, Si and M (metal) concentrations are presented by (x/(1+x)) ×100 and (1/(1+x))×100, respectively.

Thus, the shown bilayer stack according to Figure 1B constitutes a new high-k dielectric film 2 having improved characteristics. In detail, the high-nitrogen-content top layer T of the bilayer stack plays a key role to effectively prevent diffusion of e.g. boron from a boron-doped poly-Si electrode (not shown) into the field effect device channel, whereas the low-nitrogen-content bottom layer B is helpful against mobility degradation within this channel and/or the substrate 1. Moreover, since a decrease of Si content in metal-silicon-oxynitrides is related to an increase of the metal content and, in turn, an increase of the dielectric constant the bilayer stack according to the first embodiment provides a higher dielectric constant than the prior art of the similar high-Si-content metal-silicon-oxynitride. Thus, it is possible to further scale down an effective oxide thickness (EOT), while leakage particularly caused by direct tunneling is prohibited.

According to the present invention, Si and N concentrations in the top layer T need to be higher than those in the bottom layer B, e.g. xT > xB, zT > zB. A ratio of N and Si in the top layer T with respect to the bottom layer B depends further on what metal-silicon-oxides are considered. In case the metal M in the metal-silicon-oxynitride layer is Hf, which is HfSiₓOyN_{z}, the Si/(Hf+Si) ratio of HfSiₓO_{y}N_{z} needs to be in the range of 70 % to 95 % with N concentration of as high as 30 atomic percentage. Thus, for a fixed Si and N concentration in the top layer T using Hf as metal, N and Si contents of the bottom layer B need to be lower than those of the top layer T, with N atomic percentage in the range from 15 % to 25 % and a Si/(Hf+Si) ratio in the range from 20 % to 60 %.

Concerning the thickness of the different layers, it is noted that the top layer T should have a lower thickness than the thickness of the sum of the other layers within the high-k dielectric film 2 or the same. That is, the top layer T according to the bilayer structure of the first embodiment should be thinner or equal to the bottom layer B.

After formation of the high-k dielectric film 2, an anneal process (at a temperature of over 600°C in N₂ or other gas) is helpful to densify the layer stack and to reduce defects in order to improve the quality of the high-k dielectric film 2 (particularly to improve the leakage current characteristics).

Figure 2 shows a partial cross-sectional view of the high-k dielectric film according to a second embodiment, wherein same reference numbers refer to same or corresponding layers and a repeated description of these layers is omitted.

According to the second embodiment, a substrate interface layer I is formed on the surface of the substrate 1 while the respective further layers of the high-k dielectric film 2 are formed on the surface of this substrate interface layer I. In case of a Si substrate 1 this substrate interface layer constitutes preferably a silicon oxide, which further increases the mobility within the substrate and reduces defects at the surface of the substrate 1.

Besides the shown bilayer MSiₓO_{y}N_{z} stack according to the first and second embodiment having a bottom layer and a top layer of metal-silicon-oxynitride, also at least a further metal layer of metal-silicon-oxynitride could be formed between said bottom layer B and said top layer T having a further nitrogen content and a further silicon content, wherein a respective further nitrogen content and a further silicon content is between said first and second nitrogen and silicon contents of the bottom layer B and top layer T. In particular, the further nitrogen content and the further silicon content of a respectively formed middle layer is higher than the respective nitrogen and silicon contents of a metal-silicon-oxynitride layer formed in a preceding step.

The thickness of the top layer T is again equal to or lower than the sum of thicknesses of the remaining layers in the high-k dielectric film or multilayer stack, i.e. the bottom layer and the further middle layers.

Concerning the preferred method to form the above-mentioned metal-silicon-oxynitride layers, physical vapor deposition (PVD) is one of the methods to deposit various MSiₓO_{y}N_{z} layers. As one embodiment of this invention, co-sputtering of metal, such as Hf, Zr, La, Pr, Gd and other lanthanide metals, and silicon in an Ar/N₂/O₂ ambient is considered to form metal-silicon-oxynitride films. Nitrogen concentration and silicon concentration in these metal-silicon-oxynitrides can be controlled by N₂ flow and silicon sputtering rate. High nitrogen content metal-silicon-oxynitride with a small amount of silicon can be obtained using high-nitrogen flow during the co-sputtering of Si.

As one of the examples in the basic concept of this invention, a high nitrogen content and high silicon content metal-silicon-oxynitride at the top part of the high-k dielectric film 2 and a lower nitrogen content and a lower silicon content at the bottom part of the high-k dielectric film 2 can be formed to keep the interface of the high-k dielectric film 2 and (a not shown) poly-Si electrode formed usually on the top of the high-k dielectric film 2 thermally stable. Poly-Si electrode deposition usually is performed using SiH₄ or Si₂H₆ which may induce reduction of metal-O and metal-N bonds by hydrogen coming from SiH₄ or Si₂H₆, probably generating defects and, in turn, resulting in high leakage current. High nitrogen concentrations and high silicon concentrations in metal-silicon-oxynitride suppress reaction between hydrogen and the high-k dielectric film during a respective poly-Si deposition due to a number of Si-N and Si-O bonds in the place of metal-O and metal-N bonds. Similar advantages result when using a metallic material instead of poly-Si as an electrode formed on the surface of the high-k dielectric film 2.

Thus, ZrSiₓO_{y}N_{z}, HfSiₓO_{y}N_{z}, LaSiₓO_{y}N_{z}, PrSiₓO_{y}N_{z}, GdSiₓO_{y}N_{z}, DySiₓO_{y}N_{z}, and other nitrogen incorporated lanthanide-silicates can be formed as high-k dielectric films.

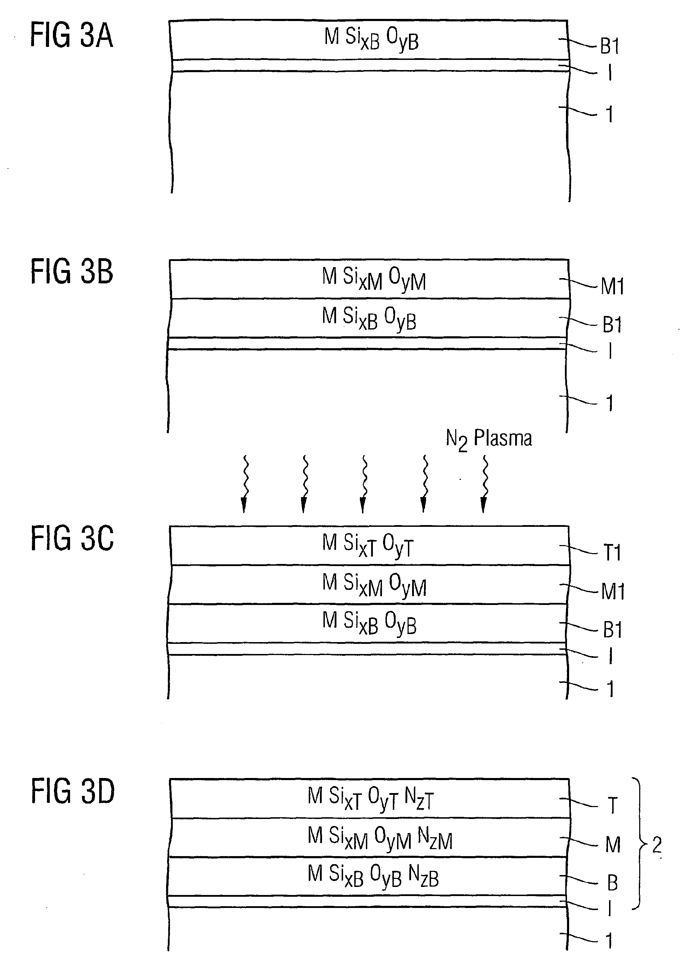

Figures 3A to 3D show partial cross-sectional views illustrating essential steps for producing a high-k dielectric film according to a third embodiment of the present invention, wherein same reference numbers refer to same or corresponding layers as in Figures 1 and 2, and, therefore, a repeated description of these layers is omitted in the following.

According to the third embodiment a triple layer stack is formed by an alternative method to provide the high-k dielectric film 2.

According to Figure 3A, again a substrate interface layer I is formed directly on the surface of the substrate 1 preferably by a thermal process. Thus, a SiO₂-substrate interface layer I is formed on the Si substrate 1. Then a pre-bottom layer B1 of metal-silicon-oxide having a low first silicon content xB is formed preferably by deposition on the substrate interface layer I.

According to Figure 3B a pre-middle layer M1 of metal-silicon-oxide having a further silicon content xM is deposited on the pre-bottom layer B1 having the first silicon content xB. Again, the further silicon content xM of the further layer or the pre-middle layer M1 is higher than that of the bottom layer B1 or (if a plurality of middle layers are to be used) is higher than that of the preceding layer.

According to Figure 3C a pre-top layer T1 of metal-silicon-oxide having a second silicon content xT is formed on the at least one pre-middle layer M1. Again, the second silicon content xT of the pre-top layer T1 is higher than the that of the pre-middle layer M1 which is higher than that of the pre-bottom layer B1.

Furthermore, an N₂ plasma treatment is made to the metal-silicon-oxide layers forming SiN bond rather than metal-N bond so that, as Si content in the different layer is different, also nitrogen contents after N₂ plasma treatment is different, respectively.

In particular, it is known that HfSiₓO_{y} can be formed by various deposition methods, such as MOCVD (Metal Organic Chemical Vapor Deposition), PVD (Physical Vapor Deposition) and ALD (Atomic Layer Deposition). In the case of MOCVD HfSiₓO_{y}, two precursors, Hf[N(C₂H₅)₂]₄ for Hf and Si[N(CH₃)₂]₄ for Si, flow into a reactor together with O₂ to deposit HfSiₓO_{y}. SiO₂ mole fraction in HfSiₓO_{y} can be controlled by process parameters, such as temperature, pressure and both precursor flow rates, during the silicate deposition.

Increase of the temperature from 325°C to 650°C was found to increase SiO₂ mole fraction in HfSiₓO_{y} from about 20 % to 65 %. Change of process pressure from 400Pa (3 Torr) to 1065 Pa (8 Torr) results in increasing SiO₂ mole fraction from 30 % to 45 %.

In the basic concept of this invention, the third embodiment of this invention uses MOCVD HfSiₓO_{y} as sequence for depositing low SiO₂ content HfSi_{xB}O_{yB} and high SiO₂ content HfSi_{xT}O_{yT} are deposited at the bottom part and at the top part of the high-k dielectric film 2 and then followed by N₂ plasma treatment. After N₂ plasma nitration, the top layer T of the film 2 shows a high nitrogen content and the bottom layer B a low nitrogen content.

In consideration of MOCVD Zr silicate instead of MOCVD Hf silicate, precursors are requested to simply change to Zr[N(C₂H₅)₂]₄ and Si[N(CH₃)₂]₄ for Zr silicate.

This embodiment of the Hf or Zr silicon-oxynitride stack using MOCVD Hf silicate or Zr silicate can be extended to for MOCVD lanthanide silicates even though various lanthanide MOCVD processes are possible.

Thus, according to Figure 3D after performing N₂ plasma treatment, the pre-bottom layer B1, the pre-middle layer M1 and the pre-top layer T1 are converted to a respective metal-silicon-oxynitride bottom layer B, middle layer M and top layer T.

Again, an annealing process after N₂ plasma treatment can be considered to release the damage of plasma on the high-k dielectric film 2, to densify the high-k dielectric film and to reduce defects as well as impurities in the high-k film stack.

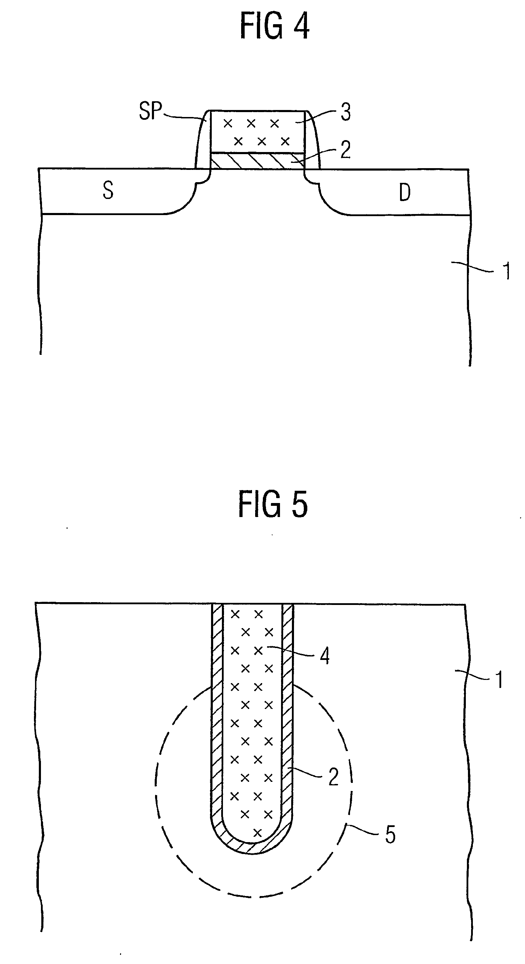

Figure 4 shows a partial cross-sectional view of a semiconductor device comprising a field effect transistor using the high-k dielectric film as a gate dielectric.

According to Figure 4 a source region S, a drain region D and a channel region between the source and drain region are provided in a semiconductor substrate 1. The high-k dielectric film 2, according to the present invention, is used as gate dielectric and formed on the channel region while a gate layer is formed on said gate dielectric 2. Furthermore, spacer SP at the side walls of the gate stack could be provided to form the source and drain regions S and D. While the gate layer 3 preferably comprises a poly-Si, it could also constitute a metal gate, thereby improving the electrical characteristics of the semiconductor device.

Figure 5 shows a partial cross-sectional view of a semiconductor device wherein the high-k dielectric film is used as a capacitor dielectric.

According to Figure 5, in order to realize so-called trench capacitors e.g. in DRAM (Dynamic Random Access Memory) semiconductor devices, a deep trench or hole is provided within the silicon substrate 1. On the surface of the trench or hole the high-k dielectric film 2 is provided after forming a second electrode 5 in the substrate 1 in the vicinity of the lower part of the trench. A filling material 4 is used as a first electrode of the resulting capacitor which is usually highly doped poly-Si or a deposited metal.

Thus, the new high-k dielectric film essentially improves the electric characteristics of semiconductor devices thereby enabling further integration densities.

It will be appreciated to those skilled in the art having the benefit of this disclosure that this invention is believed to provide a high-k dielectric film, a method for forming the same as well as related semiconductor devices having an improved leakage current by reduced tunneling currents as well as improved diffusion barrier characteristics. Further modifications and alternative embodiments of various aspects of the invention will be apparent to those skilled in the art in view of this description.

### Reference List

- 1: substrate
- 2: high-k dielectric film
- 3: gate layer
- 4: first electrode
- 5: second electrode
- B: bottom layer
- M: middle layer
- T: top layer
- B1: pre-bottom layer
- M1: pre-middle layer
- T1: pre-top layer
- I: substrate interface layer
- S: source region
- D: drain region
- SP: spacer

## Claims

1. High-k dielectric film, having a higher dielectric constant than silicon dioxide, for a semiconductor device being formed on a substrate (1) comprising at least:
a bottom layer (B) of metal-silicon-oxynitride having a first nitrogen content (zB) and a first silicon content (xB),
**characterized by**
a top layer (T) of metal-silicon-oxynitride having a second nitrogen content (zT) and a second silicon content (xT), wherein
said second nitrogen content (zT) of the top layer (T) is higher than said first nitrogen content (zB) of the bottom layer (B) and
said second silicon content (xT) of the top layer (T) is higher than said first silicon content (xB) of the bottom layer (B).

2. High-k dielectric film according to claim 1, **characterized by**
a substrate interface layer (I) of silicon-oxide being formed between said substrate (1) and said bottom layer (B).

3. High-k dielectric film according to claim 1 or 2, **characterized by**
at least one middle layer (M) of metal-silicon-oxynitride being formed between said bottom layer (B) and said top layer (T) having a further nitrogen content (zM) and a further silicon content (xM), wherein said respective further nitrogen content (zM) and further silicon content (xM) is between said first and second nitrogen and silicon contents (zT, zB, xT, xB).

4. High-k dielectric film according to any of claims 1 to 3, **characterized in that**
said bottom, middle and/or top layers consist of the same metal-silicon-oxynitride.

5. High-k dielectric film according to any of claims 1 to 4, **characterized in that**
said metal-silicon-oxynitride is ZrSiₓO_{y}N_{z}, HfSiₓO_{y}N_{z}, La-SiₓO_{y}N_{z}, PrSiₓO_{y}N_{z}, GdSiₓO_{y}N_{z} or DySiₓO_{y}N_{z}, wherein x, y and z are real positive values indicating atomic percentage in a molecular.

6. High-k dielectric film according to any of claims 1 to 5, **characterized in that**
a thickness of the top layer (T) is equal to or lower than the sum of thicknesses of the remaining layers in the high-k dielectric film (2).

7. Semiconductor device comprising a field effect transistor with a source region (S), a drain region (D) and a channel region provided in a semiconductor substrate (1), a gate dielectric (2) formed on said channel region, and a gate layer (3) formed on said gate dielectric, wherein said gate dielectric (2) consists of a high-k dielectric film according to any of claims 1 to 6.

8. Semiconductor device comprising a trench capacitor with a first electrode (4), a capacitor dielectric (2) and a second electrode (5) formed in a semiconductor substrate (1), wherein said capacitor dielectric (2) consists of a high-k dielectric film according to any of claims 1 to 6.

9. Method of forming a high-k dielectric film, having a higher dielectric constant than silicon dioxide, comprising the step:
a) forming a bottom layer (B) of metal-silicon-oxynitride having a first nitrogen content (zB) and a first silicon content (xB) on a substrate (1),
**characterized by** the step of
b) forming a top layer (T) of metal-silicon-oxynitride having a second nitrogen content (zT) and a second silicon content (xT), wherein
said second nitrogen content (zT) of the top layer (T) is higher than said first nitrogen content (zB) of the bottom layer (B) and
said second silicon content (xT) of the top layer (T) is higher than said first silicon content (xB) of the bottom layer (B).

10. Method according to claim 9, **characterized by** the further step of
forming a substrate interface layer (I) of silicon-oxide on said substrate (1) before forming said bottom layer (B).

11. Method according to claim 9 or 10, **characterized by** the further step of forming at least one middle layer (M) of metal-silicon-oxynitride having a further nitrogen content (zM) and further silicon content (xM) on said bottom layer (B), wherein a respective further nitrogen content (zM) and a further silicon content (xM) is higher than that of the preceding layer.

12. Method according to any of claims 9 to 11, **characterized in that**
said bottom, middle and/or top layers (B, M, T) are formed by co-sputtering of metal and silicon in Ar/N₂/O₂ ambient, wherein nitrogen and silicon concentration are controlled by N₂ flow and Si sputtering rate.

13. Method of forming a high-k dielectric film comprising the steps of:
a) forming a pre-bottom layer (B1) of metal-silicon-oxide having a first silicon content (xB) on a substrate (1);
b) forming a pre-top layer (T1) of metal-silicon-oxide having a second silicon content (xT), wherein
said second silicon content (xT) of the pre-top layer (T1) is higher than said first silicon content (xB) of the pre-bottom layer (B1) ; and
c) performing N2 plasma treatment to convert said pre-bottom layer (B1) to a metal-silicon-oxynitride bottom layer (B) having a first nitrogen content (zB) and said pre-top layer (T1) to a metal-silicon-oxynitride top layer (T) having a second nitrogen content (zT), wherein said second nitrogen content (zT) of the top layer (T) is higher than said first nitrogen content (zB) of the bottom layer (B).

14. Method according to claim 12, **characterized by** the further step of
forming at least one pre-middle layer (M1) of metal-silicon-oxide having a further silicon content (xM), wherein a respective further silicon content (xM) is higher than that of the preceding layer and wherein in step c) during the N₂ plasma treatment said at least one pre-middle layer (M1) is converted to at least one metal-silicon-oxynitride middle layer (M) having a further nitrogen content (zM), wherein said respective further nitrogen content (zM) is higher than that of the preceding layer.

15. Method according to any of claims 12 or 13, **characterized in that**
said pre-bottom, pre-middle and/or pre-top layers (B1, M1, T1) are formed by MOCVD, PVD and/or ALD.

16. Method according to any of claims 12 to 14, **characterized by** the further step of
forming a substrate interface layer (I) of silicon oxide on said substrate (1) before forming said pre-bottom layer (B1) in step a).

17. Method according to any of claims 9 to 16, **characterized by** the further step of
performing an anneal step at least for said said bottom, middle and/or top layers (B, M, T).

18. Method according to any of claims 9 to 17, **characterized in that**
said metal-silicon-oxynitride is ZrSiₓO_{y}N_{z}, HfSiₓO_{y}N_{z}, La-SiₓO_{y}N_{z}, PrSiₓO_{y}N_{z}, GdSiₓO_{y}N_{z} or DySiₓO_{y}N_{z}, wherein x, y and z are real positive values indicating atomic percentage in a molecular.

## Patentansprüche

1. Dielektrischer Film mit hohem k, der eine höhere dielektrische Konstante als Siliziumdioxid aufweist und für ein Halbleiterbauelement auf einem Substrat (1) ausgebildet ist mit zumindest:
einer Bodenschicht (B) aus Metall-Silizium-Oxinitrid mit einem ersten Stickstoffgehalt (zB) und einem ersten Siliziumgehalt (xB),
**gekennzeichnet durch**
eine Deckschicht (T) aus Metall-Silizium-Oxinitrid mit einem zweiten Stickstoffgehalt (zT) und einem zweiten Siliziumgehalt (xT), wobei
der zweite Stickstoffgehalt (zT) der Deckschicht (T) größer als der erste Stickstoffgehalt (zB) der Bodenschicht (B) und
der zweite Siliziumgehalt (xT) der Deckschicht (T) größer als der erste Siliziumgehalt (xB) der Bodenschicht (B) ist.

2. Dielektrischer Film mit hohem k nach Patentanspruch 1,
**gekennzeichnet durch**
eine Substrat-Zwischenschicht (I) aus Silizium-Oxid, die zwischen dem Substrat (1) und der Bodenschicht (B) ausgebildet ist.

3. Dielektrischer Film mit hohem k nach Patentanspruch 1 oder 2,
**gekennzeichnet durch**
zumindest eine Mittelschicht (M) aus Metall-Silizium-Oxinitrid, die zwischen der Bodenschicht (B) und der Deckschicht (T) mit einem weiteren Stickstoffgehalt (zM) und einem weiteren Siliziumgehalt (xM) ausgebildet ist, wobei der jeweilige weitere Stickstoffgehalt (zM) und der weitere Siliziumgehalt (xM) zwischen dem ersten und zweiten Stickstoff- und Siliziumgehalten (zT, zB, xT, xB) liegt.

4. Dielektrischer Film mit hohem k nach einem der Patentansprüche 1 bis 3,
**dadurch gekennzeichnet, dass**
die Boden-, Mittel- und/oder Deckschichten aus dem gleichen Metall-Silizium-Oxinitrid bestehen.

5. Dielektrischer Film mit hohem k nach einem der Patentansprüche 1 bis 4,
**dadurch gekennzeichnet, dass**
das Metall-Silizium-Oxinitrid ZrSiₓO_{y}N_{z}, HfSiₓO_{y}N_{z}, LaSiₓO_{y}N_{z}, PrSiₓO_{y}N_{z}, GdSiₓO_{y}N_{z} oder DySiₓO_{y}N_{z} darstellt, wobei x, y, und z reele positive Werte zum Angeben eines molekularen Atomprozentsatzes darstellen.

6. Dielektrischer Film mit hohem k nach einem der Patentansprüche 1 bis 5,
**dadurch gekennzeichnet, dass**
eine Dicke der Deckschicht (T) kleiner oder gleich einer Summe der Dicken der verbleibenden Schichten im dielektrischen Film (2) mit hohem k ist.

7. Halbleiterbauelement, das einen Feldeffekttransistor mit einem Sourcegebiet (S), einem Draingebiet (D) und einem in einem Halbleitersubstrat (1) vorgesehenen Kanalgebiet, einem Gatedielektrikum (2), welches auf dem Kanalgebiet ausgebildet ist, und einer Gateschicht (3), die auf dem Gatedielektrikum ausgebildet ist, wobei das Gatedielektrikum (2) einen dielektrischen Film mit hohem k nach einem der Patentansprüche 1 bis 6 aufweist.

8. Halbleiterbauelement, das einen Grabenkondensator mit einer ersten Elektrode (4), einem Kondensatordielektrikum (2) und einer in einem Halbleitersubstrat (1) ausgebildeten zweiten Elektrode (5) aufweist, wobei das Kondensatordielektrikum (2) einen dielektrischen Film mit hohem k nach einem der Patentansprüche 1 bis 6 aufweist.

9. Verfahren zur Herstellung eines dielektrischen Films mit hohem k mit einer höheren dielektrischen Konstante als Siliziumdioxid mit den Schritten:
a) Ausbilden einer Bodenschicht (B) aus Metall-Silizium-Oxinitrid mit einem ersten Stickstoffgehalt (zB) und einem ersten Siliziumgehalt (xB) auf einem Substrat (1),
**gekennzeichnet durch** den Schritt
b) Ausbilden einer Deckschicht (T) aus Metall-Silizium-Oxinitrid mit einem zweiten Stickstoffgehalt (zT) und einem zweiten Siliziumgehalt (xT), wobei,
der zweite Stickstoffgehalt (zT) der Deckschicht (T) größer als der erste Stickstoffgehalt (zB) der Bodenschicht (B) und der zweite Siliziumgehalt (xT) der Deckschicht (T) größer als der erste Siliziumgehalt (xB) der Bodenschicht (B) ist.

10. Verfahren nach Patentanspruch 9,
**gekennzeichnet durch** den weiteren Schritt Ausbilden einer Substrat-Zwischenschicht (I) aus Silizium-Oxid auf dem Substrat (1) vor dem Ausbilden der Bodenschicht (B).

11. Verfahren nach Patentanspruch 9 oder 10,
**gekennzeichnet durch** den weiteren Schritt Ausbilden von zumindest einer Mittelschicht (M) aus Metall-Silizium-Oxinitrid mit einem weiteren Stickstoffgehalt (zM) und einem weiteren Siliziumgehalt (xM) auf der Bodenschicht (B), wobei ein jeweiliger weiterer Stickstoffgehalt (zM) und ein weiterer Siliziumgehalt (xM) größer ist als der der jeweils vorhergehenden Schicht.

12. Verfahren nach einem der Patentansprüche 9 bis 11,
**dadurch gekennzeichnet, dass**
die Boden-, Mittel- und/oder Deckschichten (B, M, T) durch Co-Sputtern von Metall und Silizium in einer Ar/N₂/O₂-Umgebung ausgebildet werden,
wobei die Stickstoff- und Siliziumkonzentration durch den N₂-Fluss und die Si-Sputter-Rate gesteuert werden.

13. Verfahren zum Ausbilden eines dielektrischen Films mit hohem k mit den Schritten:
a) Ausbilden einer Vor-Bodenschicht (B1) aus Metall-Silizium-Oxid mit einem ersten Siliziumgehalt (xB) auf einem Substrat (1);
b) Ausbilden einer Vor-Deckschicht (T1) aus Metall-Silizium-Oxid mit einem zweiten Siliziumgehalt (xT), wobei der zweite Siliziumgehalt (xT) der Vor-Deckschicht (T1) größer ist als der erste Siliziumgehalt (xB) der Vor-Bodenschicht (B1); und
c) Durchführen einer N₂-Plasmabehandlung zum Umwandeln der Vor-Bodenschicht (B1) in eine Metall-Silizium-Oxinitrid-Bodenschicht (B) mit einem ersten Stickstoffgehalt (zB) und der Vor-Deckschicht (T1) in eine Metall-Silizium-Oxinitrid-Deckschicht (T) mit einem zweiten Stickstoffgehalt (zT), wobei
der zweite Stickstoffgehalt (zT) der Deckschicht (T) größer ist als der erste Stickstoffgehalt (zB) der Bodenschicht (B).

14. Verfahren nach Patentanspruch 12,
**gekennzeichnet durch** den weiteren Schritt Ausbilden von zumindest einer Vor-Mittelschicht (M1) aus Metall-Silizium-Oxid mit einem weiteren Siliziumgehalt (xM), wobei ein jeweiliger weiterer Siliziumgehalt (xM) größer ist als der der vorhergehenden Schicht und wobei in Schritt c) während der N₂-Plasmabehandlung die zumindest eine Vor-Mittelschicht (M1) in zumindest eine Metall-Silizium-Oxinitrid-Mittelschicht (M) mit einem weiteren Stickstoffgehalt (zM) umgewandelt wird, wobei
der jeweilige weitere Stickstoffgehalt (zM) größer ist als der der vorhergehenden Schicht.

15. Verfahren nach einem der Patentansprüche 12 oder 13,
**dadurch gekennzeichnet, dass**
die Vor-Boden-, Vor-Mittel- und/oder Vor-Deckschichten (B1, M1, T1) mittels MOCVD-, PVD- und/oder ALD-Verfahren ausgebildet werden.

16. Verfahren nach einem er Patentansprüche 12 bis 14,
**gekennzeichnet durch** den weiteren Schritt Ausbilden einer Substrat-Zwischenschicht (I) aus Siliziumoxid auf dem Substrat (1) vor dem Ausbilden der Vor-Bodenschicht (B1) in Schritt a).

17. Verfahren nach einem der Patentansprüche 9 bis 16,
**gekennzeichnet durch** den weiteren Schritt Durchführen eines Ausheilschritts für zumindest die Boden-, Mittel- und/oder Deckschichten (B, M, T).

18. Verfahren nach einem der Patentansprüche 9 bis 17,
**dadurch gekennzeichnet, dass**
das Metall-Silizium-Oxinitrid ZrSiₓO_{y}N_{z}, HfSiₓO_{y}N_{z}, LaSiₓO_{y}N_{z}, PrSiₓO_{y}N_{z}, GdSiₓO_{y}N_{z} oder DySiₓO_{y}N_{z} darstellt, wobei x, y und z reelle positive Werte zum Angeben eines molekularen Atomprozentsatzes darstellen.

## Revendications

1. Film diélectrique à k élevé ayant une constante diélectrique plus grande que celle du dioxyde de silicium, pour un dispositif à semi-conducteurs formé sur un substrat (1) comprenant au moins :
une couche (B) de fond en métal-silicium-oxynitrure ayant une première teneur (zB) en azote et une première teneur (xB) en silicium,
**caractérisé par**
une couche (T) de sommet en métal-silicium-oxynitrure ayant une deuxième teneur (zT) en azote et une deuxième teneur (xT) en silicium,
dans lequel
la deuxième teneur (zT) en azote de la couche (T) de sommet est plus grande que la première teneur (zB) en azote de la couche (B) de fond, et
la deuxième teneur (xT) en silicium de la couche (T) de sommet est plus grande que la première teneur (xB) en silicium de la couche (B) de fond.

2. Film diélectrique à k élevé suivant la revendication 1, **caractérisé par**
une couche (I) d'interface avec le substrat en oxyde de silicium formée entre le substrat (1) et la couche (B) de fond.

3. Film diélectrique à k élevé suivant la revendication 1 ou 2, **caractérisé par**
au moins une couche (M) médiane en métal-silicium-oxynitrure formée entre la couche (B) de fond et la couche (T) de sommet ayant une autre teneur (zM) en azote et une autre teneur (xM) en silicium, l'autre teneur (zM) en azote et l'autre teneur (xM) en silicium étant comprises, respectivement, entre la première et la deuxième teneurs (zT, zB) en azote et la première et la deuxième teneurs (xT, xB) en silicium.

4. Film diélectrique à k élevé suivant l'une quelconque des revendications 1 à 3, **caractérisé en ce que**
les couches de fond médiane et/ou de sommet consistent en le même métal-silicium-oxynitrure.

5. Film diélectrique à k élevé suivant l'une quelconque des revendications 1 à 4, **caractérisé en ce que**
le métal-silicium-oxynitrure est ZrSiₓO_{y}N_{z}, HfSiₓO_{y}N_{z}, LaSiₓO_{y}N_{z}" PrSiₓO_{y}N_{z}" GdSiₓO_{y}N_{z}, ou DySiₓO_{y}N_{z}, dans lesquels x, y et z sont des valeurs positives réelles indiquant un pourcentage atomique dans une molécule.

6. Film diélectrique à k élevé suivant l'une quelconque des revendications 1 à 5, **caractérisé en ce que**
une épaisseur de la couche (T) de sommet est inférieure ou égale à la somme des épaisseurs des couches restantes du film (2) diélectrique à k élevé.

7. Dispositif à semi-conducteurs comprenant un transistor à effet de champ ayant une région (S) de source, une région (D) de drain et une région de canal prévue dans un substrat (1) semi-conducteur, un diélectrique (2) de grille formé sur la région de canal et une couche (3) de grille formée sur le diélectrique de grille, le diélectrique (2) de grille consistant en un film diélectrique à k élevé suivant l'une quelconque des revendications 1 à 6.

8. Dispositif à semi-conducteurs comprenant un condensateur à sillon ayant une première électrode (4), un diélectrique (2) de condensateur et une deuxième électrode (5) formée dans un substrat (1) à semi-conducteurs, le diélectrique (2) de condensateur consistant en un film diélectrique à k élevé suivant l'une quelconque des revendications 1 à 6.

9. Procédé de formation d'un film diélectrique à k élevé ayant une constante diélectrique plus grande que celle du dioxyde de silicium comprenant les stades dans lesquels :
a) on forme une couche (B) de fond en métal-silicium-oxynitrure ayant une première teneur (zB) en azote et une première teneur (xB) en silicium sur un substrat (1),
**caractérisé par** le stade dans lequel
b) on forme une couche (T) de sommet en métal-silicium-oxynitrure ayant une deuxième teneur (zT) en azote et une deuxième teneur (xT) en silicium,
dans lequel
la deuxième teneur (zT) en azote de la couche (T) de sommet est plus grande que la première teneur (zB) en azote de la couche (B) de fond, et
la deuxième teneur (xT) en silicium de la couche (T) de sommet est lus grande que la première teneur (xB) en silicium de la couche (B) de fond.

10. Procédé suivant la revendication 9, **caractérisé par** le stade supplémentaire dans lequel
on forme une couche (I) d'interface avec le substrat en oxyde de silicium sur le substrat (1) avant de former la couche (B) de fond.

11. Procédé suivant la revendication 9 ou 10, **caractérisé par** le stade supplémentaire dans lequel
on forme au moins une couche (M) intermédiaire en métal-silicium-oxynitrure ayant une autre teneur (zM) en azote et une autre teneur (xM) en silicium sur la couche (B) de fond, une autre teneur (zM) en azote et une autre teneur (xM) en silicium étant, respectivement, plus grande que celle de la couche précédente.

12. procédé suivant l'une quelconque des revendications 9 à 11, **caractérisé en ce que**
on forme les couches (B, M, T) de fond, médiane et/ou de sommet par copulvérisation cathodique de métal et de silicium dans une atmosphère d'Ar/N₂/O₂, la concentration d'azote et de silicium étant réglée par un courant de N₂ et par une vitesse de pulvérisation cathodique de Si.

13. Procédé de formation d'un film diélectrique à k élevé comprenant les stades dans lesquels :
a) on forme une couche (B1) de préfond en métal-oxyde de silicium ayant une première teneur (xB) en silicium sur un substrat (1) ;
b) on forme une couche (T1) de présommet en métal-oxyde de silicium ayant une deuxième teneur (xT) en silicium dans lequel
la deuxième teneur (xT) en silicium de la couche (T1) de présommet est plus grande que la première teneur (xB) en silicium de la couche (B1) de préfond ; et
c) on effectue un traitement au plasma de N₂ pour transformer la couche (B1) de préfond en une couche (B) de fond en métal-silicium-oxynitrure ayant une première teneur (zB) en azote et la couche (T1) de présommet en une couche (T) de sommet en métal-silicium-oxynitrure ayant une deuxième teneur (zT) en azote, la deuxième teneur (zT) en azote de la couche (T) de sommet étant plus grande que la première teneur (zB) en azote de la couche (B) de fond.

14. Procédé suivant la revendication 12, **caractérisé par** le stade supplémentaire dans lequel
on forme au moins une couche (M1) prémédiane en métal-oxyde de silicium ayant une autre teneur (xM) en silicium, une autre teneur (xM) en silicium étant plus grande que celle de la couche précédente et dans lequel, dans le stade c), pendant le traitement au plasma de N₂, la au moins une couche (M1) prémédiane est transformée en au moins une couche (M) médiane en métal-silicium-oxynitrure ayant une autre teneur (zM) en azote, l'autre teneur (zM) en azote étant plus grande que celle de la couche précédente.

15. Procédé suivant l'une quelconque des revendications 12 ou 13, **caractérisé en ce que**
les couches (B1, M1, T1) de préfond, prémédiane et/ou de présommet sont formées par MOCVD, PVD et/ou ALD.

16. Procédé suivant l'une quelconque des revendications 12 à 14, **caractérisé par** le stade supplémentaire dans lequel
on forme une couche (I) d'interface avec le substrat en oxyde de silicium sur le substrat (1) avant de former la couche (B1) de préfond au stade a).

17. Procédé suivant l'une quelconque des revendications 9 à 16, **caractérisé par** le stade supplémentaire dans lequel
on effectue un stade de recuit au moins pour les couches (B, M, T) de fond, médiane et/ou de sommet.

18. Procédé suivant l'une quelconque des revendications 9 à 17, **caractérisé en ce que**
le métal-silicium-oxynitrure est ZrSiₓO_{y}N_{z}, HfSiₓO_{y}N_{z}, LaSiₓO_{y}N_{z},, PrSiₓO_{y}N_{z},, GdSiₓO_{y}N_{z}, ou DySiₓO_{y}N_{z}, dans lesquels x, y et z sont des valeurs positives réelles indiquant un pourcentage atomique dans une molécule.
